# EUROPEAN PATENT APPLICATION

(11) **EP 0 751 554 A2**
(43) Date of publication of application: **02.01.1997**
(21) Application number: 96304238.7
(22) Date of filing: 06.06.1996
(51) Int. Cl.: H01L 21/306, C23C 16/44

(54) **Method of in-situ cleaning of deposits from sputter clean chambers**

(30) Priority: 07.06.1995 US 474591
(71) Applicant: VARIAN ASSOCIATES, INC., Palo Alto, California 94304 (US)
(72) Inventor: Salimian, Siamak, Sunnyvale, California (US)
(74) Representative: Cline, Roger Ledlie

(57) **Abstract**

A method for in situ cleaning of the interior of a sputter clean chamber with either a pure H₂ gas or a mixture of Ar and H₂ gases. This process will quickly remove relatively thick contaminating films of silicon material without introducing highly reactive or corrosive gases into the chamber. In essence, the process includes: pre-cleaning a predetermined number of silicon wafers with a conventional argon sputter etch module in a PVD metallization tool; after a plurality of wafers have been etched, introducing a cleaning gas comprising either pure H₂ or a mixture of H₂ and Ar; exciting a plasma with the cleaning gas for a predetermined period of time while flowing the cleaning gas through the reactor so as to help remove contaminating matter; and removing the cleaning gas and proceeding with wafer pre-cleaning.

## Description

### Field of the Invention

The present invention is directed to a method of in-situ cleaning of deposits from physical vapor deposition (PVD) sputter clean chambers used in semiconductor device fabrication. Sputter clean chambers are commonly used in cluster tools for the physical cleaning of substrate surfaces with a sputter etching process prior to metal deposition processes. A typical sputter clean process uses an argon plasma with ion energies in the range of about 100 - 1000 V depending upon the reactor design. The byproducts of this sputter clean process deposit upon the walls and/or shields of the reactor and will eventually flake off, causing particulate contamination of the substrates being cleaned. As a result, all reactors utilized in the manufacturing of semiconductor devices require periodic replacement and cleaning of the walls and/or shields to avoid this contamination. Such periodic maintenance reduces the "uptime" of the reactor and presents an undesirable bottleneck in the semiconductor device fabrication process. It commonly requires from four to eight hours of "downtime" to completely service contaminated shields and bring the chamber back to operating parameters. Such maintenance generally requires that the chamber be opened to clean room atmosphere, parts replaced, and the chamber be brought back down to vacuum. Clean room atmosphere is essentially never as clean as the vacuum of the sputter clean chamber during production operations, thus it is highly undesirable to open the chamber to a source of relative contamination any more than absolutely necessary.

### Background of the Invention

Recently, demand for reduced feature size and increased device density on larger diameter silicon wafers has led to the emergence of the integrated cluster tool for semiconductor device fabrication. The integrated cluster tool is a multi-chamber vacuum system in which a number of working chambers are arranged around a central transfer chamber and in which each working chamber is isolated from the central transfer chamber by a pair of gate valves forming a vacuum lock. During operation, a semiconductor wafer can be processed in a working chamber, while the rest of the cluster apparatus is isolated from the environment of any of the other working chambers. After a wafer treatment is completed in a particular working chamber, the wafer is automatically passed back to the central transfer chamber through the vacuum lock and then passed automatically to a subsequent working chamber through another vacuum lock. The integrated cluster tool permits a plurality of various vacuum working chambers to be "clustered" around the central transfer chamber and permits the processing of a wafer through many of its most demanding processes without any requirement for the wafer to be passed back into ambient or clean room air. The integrated cluster tool is essentially a serial processing device. Typically, loads of 25 wafers are sequentially processed, one at a time, through the various processes of the cluster tool. Accordingly, high fabrication output rates depend upon utilizing a minimum of time in each processing step and maintaining the cluster tool operating a high percentage of the time.

Cluster tools for physical vapor deposition (PVD) of metallic films typically include a single pre-clean module (or reactor) utilizing a sputter etch process to remove oxide and other material from silicon wafers prior to deposition of metallic films. This is generally referred to as a pre-clean process or step.

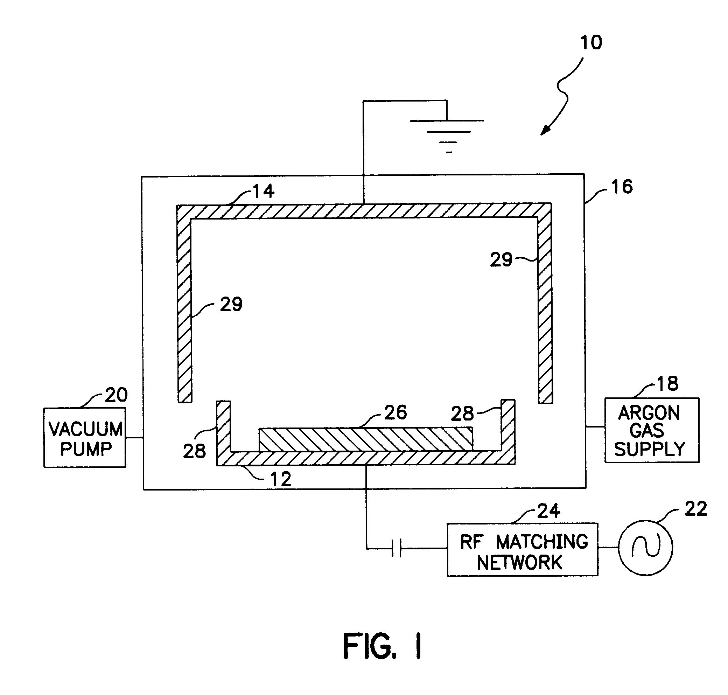

A typical prior art diode reactor 10 as is used in some existing pre-clean modules is shown in FIG. 1. The diode reactor comprises a powered electrode 12 and a grounded electrode 14 disposed within a vacuum chamber 16. An argon gas supply 18 communicates with the chamber 16 via appropriate control valves and systems (not shown) as well known to those of skill in the art. A vacuum pump 20, generally a cryo-pump or a turbo-molecular pump is used to control the pressure in the chamber 16. An RF power supply 22 supplies RF excitation to powered electrode 12 via RF matching network 24 which is capacitively coupled to powered electrode 12. A wafer 26 is disposed face up on a wafer table (not shown) disposed on powered electrode 12. Shield 28 surrounds wafer 26 on powered electrode 12 and shield 29 surrounds grounded electrode 14.

Normal use of reactor 10 to remove silicon bearing materials and other surface contaminants from silicon wafers results in the deposition of these materials on the shields 28 and 29. For example, a typical pre-clean step removes about 200Å of silicon bearing material from a wafer surface. Processing 1000 wafers will result in the removal of 200,000 Å (20µm) of material from the wafers which becomes an undesirable and thick contaminating film. A number of techniques have been developed to increase the amount of deposits that the interior surfaces of the reactor will bear before they have to be replaced and/or cleaned. Well known in the prior art is the technique of perforating the surfaces of the shields. Perforation allows the contaminants to pass through the perforations and coat the outside of the shields and other parts of the interior of the reactor. This effectively increases the surface area of the shields and increases the required replacement interval. Also well known in the prior art are techniques of surface treatment of the shields to increase the deposit load that they will bear. Bead blasting, sand blasting and sputter etching the shields themselves, prior to use, increases the adhesion of the surfaces of the shields so that they will retain more deposits before exfoliating particles of the deposits. Such particles may land on the wafer surface and introduce defects which will reduce manufacturing yields.

U.S. Patent No. 5,294,320 to Somekh et al. teaches a method of in situ chemical cleaning of the shields of a PVD reactor used for metal deposition. Somekh et al. teach that a gas mixture including a reactive gas such as NF₃, CF₄, SF₆, Cl₂, or BCl₂ activated by the plasma discharge in the chamber at a pressure of 0.13 to 133 Pa is effective in chemically etching and removing excess deposition material from the shields. The introduction of Fluorine and Chlorine bearing gases into the PVT chamber requires a further argon bombardment step to remove from the chamber and/or passivate these corrosive materials.

U.S. Patent 5,304,405 to Kobayashi et al. teaches a plasma clean cycle method for in situ cleaning of silicon-containing deposited films from a sputter clean chamber of a PVD cluster reactor. The method claimed involves an inspection step to determine a particulate contamination level and, on the occurrence of a particulate contamination level exceeding a predetermined threshold, a cleaning cycle is begun. The cleaning cycle involves introducing a reactive gas which is excited by an argon plasma and chemically etches silicon containing films deposited on the shields of the reactor. The reactive gasses taught by Kobayashi et al. to achieve the desired cleaning are CF₄, CF₄ + O₂, NF₃, and Chlorine-based gasses. By cycling the gas in the reactor, the silicon is removed as it reacts with the reactive gas, thus reducing the thickness of the contaminating silicon films within the reactor. A heating system is also optionally employed to speed the reaction by direct heating of the shields.

While Chlorine and Fluorine-based gasses, as taught by Kobayashi et al. and Somekh et al. will undoubtedly etch silicon bearing films, they pose a problem when used with sputter clean chambers. Highly corrosive gasses such as those containing Fluorine and Chlorine are generally considered unsuitable, or at least problematic, for use in a PVD metallization cluster module. Chlorine and Fluorine are both highly reactive gasses which react readily with Aluminum and Titanium which are generally present in the other chambers of a metallization cluster tool. Fluorine, and particularly Chlorine, which were to escape the sputter clean chamber and cross contaminate a metallization chamber could damage wafers being fabricated. A buffer chamber could be used, at a significant added expense, to help reduce the possibility of reactive gas contamination, but because both Fluorine and Chlorine are readily chemisorbed and physisorbed into the metal walls of the chamber, they are extremely difficult to remove from the chamber by simply pumping the chamber down to a vacuum. Removal also generally requires a heating step to free these reactive chemicals from the chamber walls which may require additional powered equipment. Typical cluster tools are expected to process 15 to 60 wafers per hour in 25 wafer lots, one at a time. Typical sputter clean processes are expected to take a total of 30 - 120 seconds to complete. The additional processes involved in adding buffer chambers and heating steps to avoid the consequences of using Fluorine and Chlorine are expensive and add additional complexity to the fabrication process. Thus, it would be desirable to be able to clean the pre-clean module vacuum chamber without introducing Chlorine, Fluorine or other highly reactive gases into the cluster tool.

U.S. Patent No. 5,376,223 to Salimian et al teaches a plasma etch process employing a high ion density/low pressure plasma of about 0.32 Pa in an ECR reactor with H₂ or H₂ + Ar as the plasma gas is effective in removing thin native films (about 30 Å) of SiO₂ from silicon wafers in approximately 60 seconds or less.

Accordingly, there is a need for an improved cleaner, faster and noncorrosive process for in situ cleaning of silicon-containing films from a sputter clean chamber and its component parts which does not require opening the chamber for parts replacement.

The invention is set out in claim 1.

An example of the prior art and of the invention will now be described with reference to the accompanying drawings in which:
Fig. 1 is a schematic diagram of a prior art diode reactor;
Fig. 2 is a schematic diagram of a triode reactor as used in an embodiment of the invention; and
Fig. 3 is a schematic diagram of an inductively coupled plasma (ICP) reactor as used in an embodiment of the invention.

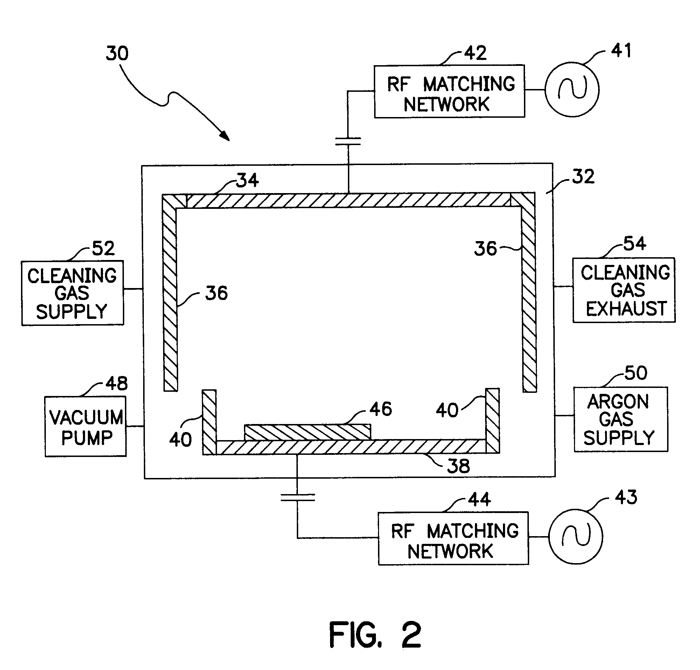

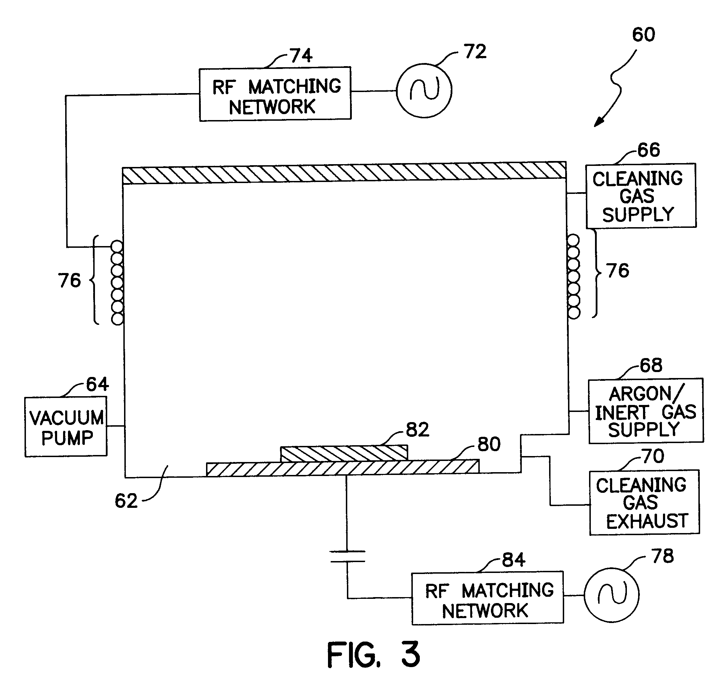

A preferred embodiment of the present invention is implemented for use with a triode reactor as shown in schematic diagram at FIG. 2. The present invention may also be used with other reactors capable of generating a relatively ion dense plasma (approximately 10¹¹ ions/cc), such as ICP reactors (FIG. 3), electron cyclotron resonance (ECR) reactors, and the like for rapid etching. Triode reactor 30 as shown in FIG. 2 is a dual frequency capacitively coupled reactor and comprises a reactor vacuum chamber 32, a first powered electrode 34 a shield 36, a second powered electrode 38, a shield 40, a first RF power supply 41 ("plasma RF power supply") which drives first powered electrode 34 through an RF matching network 42 and a capacitive coupling to form the plasma. Second powered electrode 38 is biased by means of capacitively coupled second RF power supply 43 ("bias RF power supply") which also employs an RF matching network 44 as well known in the art. Wafer 46 is positioned, preferably by a robotic device (not shown), as shown on second powered electrode 38. The configuration may also be inverted so that gravity assists in keeping particulate contamination off of wafer 46. Different plasma generation configurations may also be used as well known to those of ordinary skill in the art. Chamber 32 is provided with a conventional turbo-molecular vacuum pump 48 (or other pump useable with hydrogen gas) and an argon gas supply 50 (other inert gasses and combinations of inert gasses may be used instead such as Ar, Kr, Xe, etc.). These are controlled with appropriate control systems and valves as known to those of skill in the art. A cleaning gas supply 52 and a cleaning gas exhaust 54 (which may be part of the vacuum pump 48) are provided.

Use of the system is as follows: a predetermined number of wafers are pre-cleaned in a conventional manner using argon ion bombardment powered by a plasma driven by plasma RF power supply 41. Each wafer processed will result in the deposition of a certain thickness of contaminating silicon film within the reactor, and particularly on shields 36 and 40. Once a threshold thickness is reached for a given process (this will necessarily vary from process to process, on the type of wafers used, on the precise physical configuration of the reactor, on the etch gas pressure, the RF power applied, and the electrical configuration of the reactor) a cleaning cycle will be initiated. The timing of this process will typically be determined by a user based upon the user's particular setup. Since a given amount of material will be deposited after each predetermined number of wafers are pre-cleaned, and since the thickness of the resulting film will be relatively constant, a similar cleaning cycle may be used repeatedly. The goal of the cleaning cycle is to extend the operation of the reactor, not necessarily to make it completely clean of silicon film residue. During the cleaning cycle, no wafer is present in the chamber, however, a protective aluminum plate or disk may preferably be used to protect the second powered electrode 38 and wafer support table (which is electrically a part of the second powered electrode) from etching. The cleaning gas is introduced into the chamber from the cleaning gas supply 52 and removed through the cleaning gas exhaust 54 (which may be part of vacuum pump 48 or a separate system). A plasma is struck between first powered electrode 34 and second powered electrode 38 in the conventional manner, the silicon film on the shields 36, 40 is reacted chemically with the cleaning gas and the resulting silicon containing gas is exhausted through cleaning gas exhaust 54. Preferably, an optimum time is determined to allow the cleaning process to continue. This will vary from process to process -- for example, if another event requires shutdown of the line after a given number of hours, the cleaning process will be optimized to allow the pre-clean chamber to operate with under-threshold silicon film thickness for those given number of hours, and shield removal could be carried out at the same time that the line is down for other maintenance. There may be no point in removing all or substantially all of the silicon film during a cleaning cycle as that might take more time than necessary and delay processing of the wafers.

It is expected that the cleaning process would normally be conducted at different conditions of pressure, power and gas flow than are normally used for silicon wafer etching within the reactor. For example, it is expected that the pressure used would be relatively high, in the range of 0.13 to 13 Pa depending upon the particular reactor configuration and pump (normal reactor pressure for argon plasma for sputter cleaning is about 0.06 to 1.3 Pa. The power used would preferably be the maximum power deliverable by the plasma RF power supply 41 (approximately 1000 J/sec or more), and the gas flow would be relatively high to accommodate the removal of silicon-containing gasses from the vacuum chamber 32.

Once the cleaning cycle is completed, no further steps are required other than a standard conditioning step (where an argon plasma etch of a dummy oxide wafer would be carried out for a few minutes) to go back to wafer pre-cleaning except for a pump down to vacuum to remove any free H₂ in the chamber.

The cleaning gas is preferably (1) H₂; or (2) a combination of H₂ and Ar. It is also possible to substitute Xe or Kr for or add Xe or Kr to the Ar of option (2). These gases are preferred because they are non-corrosive, do not present a contamination issue to the pre-clean chamber, and are non-toxic and relatively inexpensive.

Turning now to FIG. 3, an ICP reactor 60 useable with the present invention is shown. ICP reactor 60 includes a vacuum working chamber 62 and a turbo-molecular pump 64 (or other pump useable with hydrogen gas) for controlling the pressure within working chamber 62. A cleaning gas supply 66, argon/inert gas supply 68, and cleaning gas exhaust 70 are provided as described above for the triode reactor 30. A plasma RF power supply 72 is coupled to the working chamber 62 to deliver energy for forming and sustaining a plasma within vacuum chamber 62 by means of a first RF matching network 74 and an inductive coil or solenoid 76 which surrounds working chamber 62. A bias RF power supply 78 is coupled to powered electrode 80 which supports wafer 82 by an RF Matching Network 84 which is capacitively coupled to powered electrode 80 in the conventional manner.

It should be noted that while pre-clean systems are not commonly used with chemical vapor deposition (CVD) cluster tools and the like, the present invention could also be used with such tools.

## Claims

1. A silicon wafer cleaning process including a chamber cleaning process executed in a vacuum chamber, said process comprising:
(a) etching a silicon wafer with an inert gas which is introduced into the vacuum chamber and afterward transformed into a first plasma in said vacuum chamber;
(b) removing the silicon wafer from said vacuum chamber;
(c) introducing a fluorine-free, chlorine-free cleaning gas comprising H₂ into said vacuum chamber;
(d) transforming said cleaning gas into a second plasma and reacting said second plasma and cleaning gas with silicon containing deposits within said vacuum chamber to form silicon containing gases;
(e) evacuating said silicon containing gases from said vacuum chamber while said second plasma is in existence.

2. A process for use in a vacuum chamber having a wafer support table, said wafer being one of a plurality which are etched, one by one, with an inert gas which is introduced into the vacuum chamber and afterward transformed into a first plasma in said vacuum chamber and above said wafer support table; the process comprising, after the removal of said plurality of silicon wafers from said vacuum chamber, placing an aluminum plate upon the wafer support table to protect the wafer support table from etching before introducing the fluorine-free, chlorine-free cleaning gas comprising H₂ into said vacuum chamber.

3. A process as claimed in claim 1 or claim 2 comprising the further steps of
(f) forming a vacuum in said vacuum chamber;
(g) without having exposed the vacuum chamber to ambient pressure during the previous steps, etching a further silicon wafer with an inert gas which is introduced into the vacuum chamber and afterward transformed into a first plasma in said vacuum chamber.

4. A process as claimed in any one of claims 1 to 3 wherein said cleaning gas comprises substantially pure H₂.

5. A process as claimed in any one of claims 1 to 3 wherein said cleaning gas comprises a combination of substantially pure H₂ and Ar.

6. A process as claimed in any one of claims 1 to 3 wherein the cleaning gas comprises a gas comprising substantially pure H₂ and another gas selected from the group consisting of: Ar, Kr, Xe, and combinations thereof.

7. A process as claimed in any one of claims 1 to 6 wherein said inert gas is a gas selected from the group consisting of: Ar, Kr, Xe, and combinations thereof.
